# EUROPEAN PATENT SPECIFICATION

(11) **EP 1 845 761 B1**
(45) Date of publication and mention of the grant of the patent: **22.06.2011**
(21) Application number: 06712596.3
(22) Date of filing: 30.01.2006
(51) Int. Cl.: H05K 3/46, H05K 3/34

(54) **MULTILAYER PRINTED WIRING BOARD**
MEHRSCHICHTIGE LEITERPLATTE
CARTE DE CABLAGE IMPRIMEE MULTICOUCHE

(30) Priority: 02.02.2005 JP 2005026896
(43) Date of publication of application: 17.10.2007
(73) Proprietor: IBIDEN CO., LTD., Ogaki-shi, Gifu 503-0917 (JP)
(72) Inventor: WU, Youhong, Ibi-gun Gifu, 5010695 (JP)
(74) Representative: Grünecker, Kinkeldey, Stockmair & Schwanhäusser Anwaltssozietät
(86) International application number: PCT/JP2006/301453
(87) International publication number: WO 2006/082783

(56) References cited:
- EP-A- 0 969 707
- EP-A- 1 011 139
- EP-A- 1 117 283
- JP-A- 9 298 364
- JP-A- 2000 165 046
- JP-A- 2001 044 640
- JP-A- 2001 044 640
- JP-A- 2002 094 240
- JP-A- 2003 152 311
- JP-A- 2003 152 311

## Description

### Field of the Invention

The present invention relates to a multi-layer printed wiring board. More specifically, the present invention relates to a buildup multi-layer printed wiring board preferably used for a package substrate for mounting an IC chip.

### Background of the Invention

In a buildup-type multi-layer printed wiring board constituting a package for IC chips, interlayer insulation resin is formed on both surfaces or one surface of a core substrate upon which throughholes are made with a drill. Then, via holes used for interlayer conduction are opened by laser or photoetching to form an interlayer resin insulation layer. On the inner wall of the via hole is formed a conductor layer by plating or the like. Then, a pattern is made by using etching or the like so as to form a conductor circuit. Moreover, a buildup multi-layer printed wiring board is made by repetitively forming an interlayer insulation layer and a conductor layer. In the latest buildup multi-layer wiring board, a conductor layer (cover plated layer) is placed such that it covers the surface of a throughhole and a via hole is formed on the cover plated layer in order to increase wiring density of the throughhole and buildup layer.

Patent literatures 1 and 2 are related to conventional buildup multi-layer wiring boards having throughholes with cover plated layers.
Patent Literature 1: Japanese Unexamined Patent Publication No. 2001-127435
Patent Literature 2: Japanese Unexamined Patent Publication No. 2002-208778

EP 1117283 discloses a printed wiring board and a manufacturing method for fabricating a high-density wiring and a highly-reliable connection between conductor layers.

### Disclosure of the Invention

### Problems that the Invention is to Solve

If a via hole is formed on a cover plated layer so as to shorten the length of wiring, as described above, the reliability of the via hole tends to decline, so much so that it is difficult to make the diameter of the via hole smaller. In general, if the bottom diameter of a via hole is small, the contact area between the conductor formed on the via hole and the land becomes small, and the bonding strength between the via hole and the land declines. When a heat cycle test or the like is performed, connection resistance tends to increase between them.

In the via hole of the buildup multi-layer wiring board, an electroless plating film is formed before an electrolytic plating film. The electroless plating film, which is formed first, is fragile because it contains organic materials, hydrogen molecules, hydrogen atoms, and the like. Therefore, cracks may tend to occur in the electroless plating film. Also, an electroless plating film tends to detach from a land if warping occurs on the printed wiring board at a time when IC chips are mounted, because an electroless plating film has lower ductility and cannot warp accordingly

The present invention was designed to solve the abovementioned problems. The object of the invention is to provide a multi-layer printed wiring board that avoids decrease in connection reliability by using a via hole of a small diameter.

### Means of Solving the Problems

After intense study, the present inventor found that the reliability of via holes declines in specific sites on a multi-layer printed wiring board.

It has been found by simulations that a via hole which is formed on a cover-like conductor layer (cover plated layer) and has a large portion of the bottom section of the via hole formed on a throughhole receives a smaller stress during a heat cycle, as compared with a via hole (second via hole) formed on the second interlayer resin insulation layer.

According to Claim 1, a via hole which is formed on a cover-like conductor layer (cover plated layer) and placed inside a circle having a radius ((R) + (r)/3) from the center of gravity of a throughhole has a bottom radius smaller than that of a via hole formed on the second interlayer resin insulation layer (where, the radius of the throughhole is (R), and the radius of the via hole on the cover plated layer is (r)). By forming such a via hole having a small radius, integration degree is increased without reducing connection reliability.

In the case that a via hole is not a circle but an oval or a polygon, the numeral (r) is 1/2 of the length of a line connecting both ends (two farthest points) of outer circumference. This is also true for a throughhole. The numeral (r) is 1/2 of the longitudinal diameter of an oval and 1/2 of the diagonal line of a rectangle.

### The Best Mode for Implementing the Invention

### [First Embodiment]

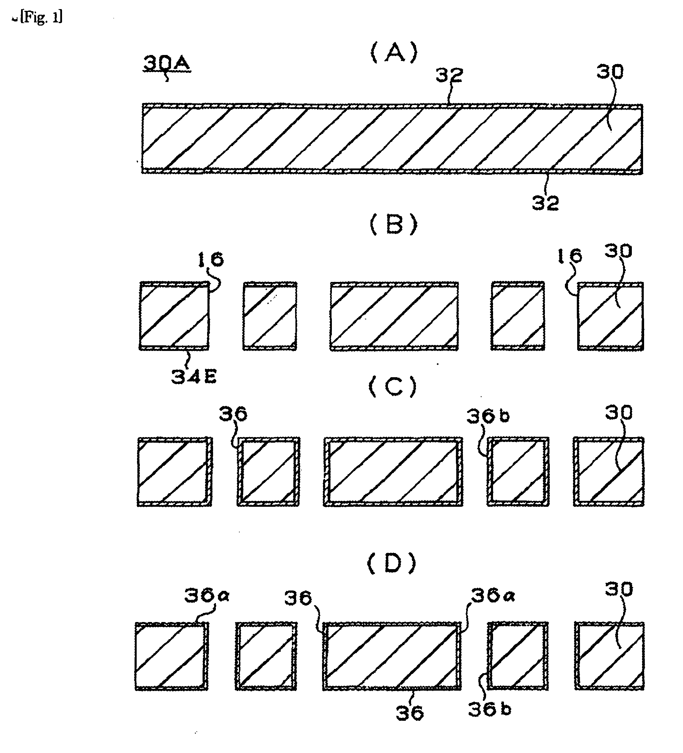

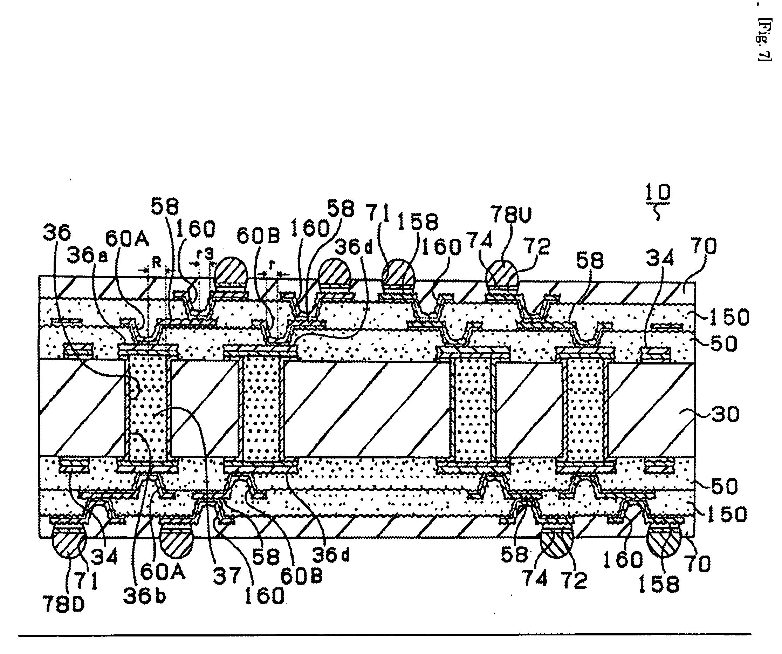

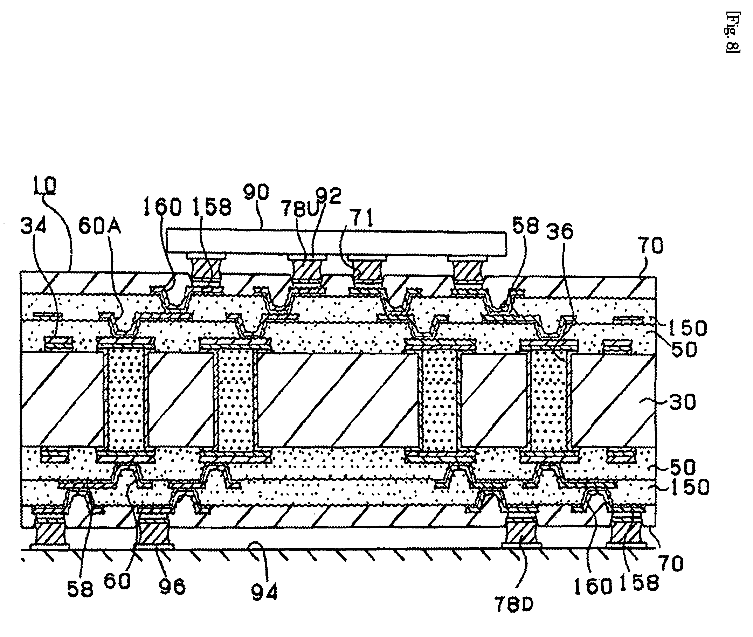

A description of the constitution of a multi-layer printed wiring board 10 according to the first embodiment of the present invention is given below by referring to Fig. 1 - Fig. 8. Fig. 7 is a sectional view of the multi-layer printed wiring board 10. In Fig. 8, an IC chip 90 is mounted on the multi-layer printed wiring board 10 as shown in Fig. 7 and placed on a daughterboard 94. In the multi-layer printed wiring board 10, as shown in Fig. 7, a conductor circuit 34 is formed on the surfaces of a core substrate 30. The front and rear surfaces of the core substrate 30 are connected with each other by a throughhole 36. The throughhole 36 is made up of a sidewall conductor layer 36b and cover plated layers 36a and 36d that constitute a throughhole land. Inside of the sidewall conductor layer 36b is filled with resin fillers 37. It may be filled with copper alone without resin fillers. An interlayer resin insulation layer 50 and an interlayer resin insulation layer 150 are provided on the cover plated layers (throughhole lands) 36a and 36d. The interlayer resin insulation layer 50 has via holes 60A and 60B and a conductor circuit 58, and the interlayer resin insulation layer 150 has a via hole 160 and a conductor circuit 158. A solder resist layer 70 is formed above the via hole 160 and conductor circuit 158. Bumps 78U and 78D are formed on the via hole 160 and conductor circuit 158 through the opening 71 of the solder resist layer 70.

As shown in Fig. 8, a solder bump 78U on the top side of the multi-layer printed wiring board is connected to a land 92 of the IC chip 90. On the other hand, a solder bump 78D on the bottom side is connected to a land 96 of the daughterboard 94.

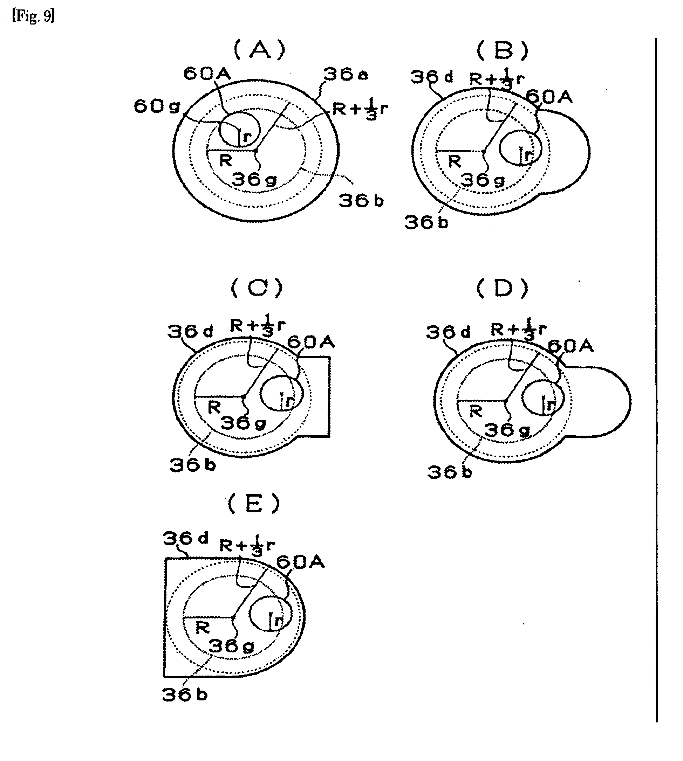

Fig. 9 (A) is a plan view of the cover plated layer (throughhole land) 36a. The opening for a throughhole is made to 0.08mm ∼ 0.25mm in size with a drill. The cover plated layer 36a is made circular. The bottom section of the via hole 60A on the cover plated layer 36a is formed inside a circle having a radius ((R) + (r)/3) from the center of gravity 36g of the throughhole (where, the radius of the opening 16 of the throughhole is (R), and the bottom radius of the via hole 60A, whose center of gravity is 60g, is (r)). In this embodiment, the radius (R) of the opening 16 of the throughhole is 50µm and the bottom radius (r) of the via hole 60A 22.5µm. On the other hand, the bottom radius (r3) of the via hole 160 formed on the interlayer insulation layer 150 above the via hole 60A is 25µm. Figs. 9 (C), (D), and (E) show other possibility of the position of the cover plated layer (throughhole land) 36 and the first via hole.

Fig. 9 (B) shows another form of the cover plated layer (throughhole land). The cover plated layer 36d is snowman-shaped (i.e., two semicircles are combined). Just as the via hole 60A, the bottom of the via hole 60B on the cover plated layer 36d is formed inside a circle having a radius ((R) + (r)/3) from the center of gravity 36g of the throughhole.

The following is the simulation results of stress applied during a heat cycle to the via holes 60A and 60B on the cover plated layers 36a and 36d and the via holes 160 formed above those via holes.

Here, 3D thermal stress simulation with a finite element method (FEM) was conducted. If the structure under analysis contains material that is marked in plasticity and creep characteristic such as solder, non-linear thermal stress simulation is necessary, taking the plasticity and creep characteristic into consideration. Therefore, thermal stress during thermal impact tests on micro vias of a high-density and multi-layer organic package was analyzed with a multi-scaling (sub-modeling) method. Specifically, a model including the entire substrate was analyzed with a coarse mesh, a variation calculated based on the analysis was used as a boundary condition of a sub-model divided by a minute mesh, and the sections of interest were carefully analyzed. In other words, a coarse model of a package was analyzed, variation was set as a boundary condition of a sub-model, and a non-linear thermal stress analysis was conducted under the conditions of thermal impact tests (-55°C ∼ 125°C), taking the plasticity of solder into consideration.

As a result, it was found that 35 MPa was applied to the via hole 60A or 60B that was formed on the cover plated layers 36a and 36d and whose bottom was placed inside a circle of a radius ((R) + (r)/3) as described above, and 90 MPa was applied to the via hole 160 formed on the upper layer of the via hole.

In other words, the stress applied during a heat cycle to the via hole 60A or 60B that is formed on the cover-like conductor layers (cover plated layers) 36a or 36d and whose bottom is placed inside a circle having a radius ((R) + (r)/3) from the center of gravity 36g of a throughhole is smaller than the stress applied to the via hole 160 formed on the second interlayer resin insulation layer 150.

Accordingly, in the first embodiment, integration degree was increased without reducing connection reliability by using a via hole of the minimum radius in each region and by making the bottom radius (r) of a via hole that is formed on the cover-like conductor layer (cover plated layer) 36a and whose bottom is placed inside a circle of a radius ((R) + (r)/3) from the center of gravity of the throughhole smaller than the bottom radius (r3) of the via hole 160 formed on the second interlayer resin insulation layer 150.

It is more significant to apply the present invention to a structure where the bottom radius of a second via hole is 30µm or less, the radius of the opening of a throughhole is 100µm or less, and a throughhole pitch is 385µm or less. This is because a printed wiring board is liable to warp by environmental changes when the core has throughholes of a small radius arranged in a narrow pitch, and stress tends to be concentrated on the second via hole.

Figs. 9 (C), (D), and (E) show other exemplary shapes of cover plated layers. As the drawings show, it is not necessary to make a cover plated layer snowman-shaped. In the case of Fig. 9 (E), the cover plated layer 36d protrudes only in the direction that a via hole is mounted relative to the opening of the throughhole (inner radius) 36b. It is therefore possible to make throughhole pitches narrow-pitched and achieve densification.

The method of producing the abovementioned multi-layer printed wiring board 10 described based on Fig. 7 is explained below by referring Figs. 1- 6.
(1) The starting material was a copper clad laminated plate 30A by laminating copper foils 32 of 5 - 250µm on both surfaces of an insulative substrate 30 of 0.2 - 0.8mm in thickness made of glass epoxy resin or BT (Bismaleimide-Triazine) resin (Fig. 1 (A)). First, the copper clad laminated plate is drilled to make a hole 16 (Fig. 1(B)). Then, electroless plating and electrolytic plating were carried out to form the sidewall conductor layer 36b of the throughhole 36 (Fig. 1 (C)). The opening of the hole 16 was made to 0.1 ∼ 0.25mm Ø with a drill, and its pitch 0.15 ∼ 0.575mm.

(2) The substrate 30 on which the throughhole 36 is formed was washed with water. After drying, coarse surfaces 36α were formed on the sidewall conductor layer 36b of the throughhole 36 and other surfaces by black oxide treatment using as black oxidizing solution (oxidizing bath) an aqueous solution containing NaOH (10 g/L), NaClO₂ (40 g/L), Na3PO₄ (6 g/L) and by reduction treatment using as reduction bath an aqueous solution containing NaOH (10 g/L) and NaBH4 (6 g/L) (Fig. 1 (D)).

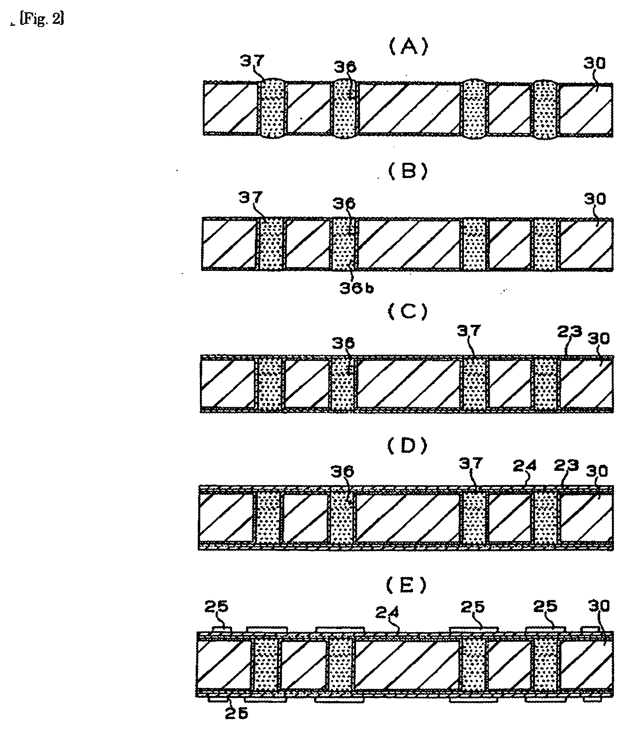

(3) Next, the throughhole 36 was filled with a filler 37 (non-conductive copper filling paste made by Tatsuta Electric Wire & Cable Co., Ltd.; brand name, DD paste) containing copper particles of 10µm in average diameter by using a screen printing method and dried to be solidified (Fig. 2 (A)). In other words, the throughhole was filled with the filler by applying it to the substrate having masks with openings in throughhole portions by using a printing method, and subsequently it was dried and solidified.

Then, the filler 37 that stuck out from the throughhole 36 was removed by belt sander grinding using # 600 belt polishing paper (made by Sankyo Rikagaku Co., Ltd.). Buffing for removing scratches caused by the belt sander grinding was conducted to smooth out the surfaces of the substrate 30 (see Fig. 2 (B)). The substrate 30 thus formed had the sidewall conductor layer 36b of the throughhole 36 and the resin filler 37 tightly attached to each other through the coarse layer 36.

(4) A palladium catalyst (made by Atotec Japan Co., Ltd.) was applied to the surface of the substrate 30 that had been smoothed out in the above (3). Then, it was subjected to electroless copper plating to form an electroless copper plating film 23 of 0.6µm in thickness (see Fig. 2 (C)).

(5) Electrolytic copper plating was carried out under the conditions as shown below to form an electrolytic copper plating film 24 of 15µm in thickness, forming the portion to be the conductor circuit 34 and the portion to be the cover plated layer (throughhole land) to cover the filler 37 of the throughhole 36 (Fig. 2 (D)).

### [Aqueous electrolytic plating solution]

| | |
|---|---|
| Sulfuric acid | 180 g/L |
| Copper sulfate | 80 g/L |
| Additive (made by Atotec Japan; brand name, Caparasid GL) | 1 mL/L |

### [Electrolytic plating conditions]

| | |
|---|---|
| Current density | 1 A/dm² |
| Time | 70 minutes |
| Temperature | room temperature |

(6) On both surfaces of the substrate 30 on which the portions for the conductor circuit and the cover plated layer had been formed, a commercially available photosensitive dry film was attached, and a mask was mounted. Then, it was exposed to light (100 mJ/cm²) and developed with 0.8% sodium carbonate to form an etching resist 25 of 15µm in thickness (see Fig. 2 (E)). The shape pf the cover plated layer can be changed by adjusting the pattern of a mask.

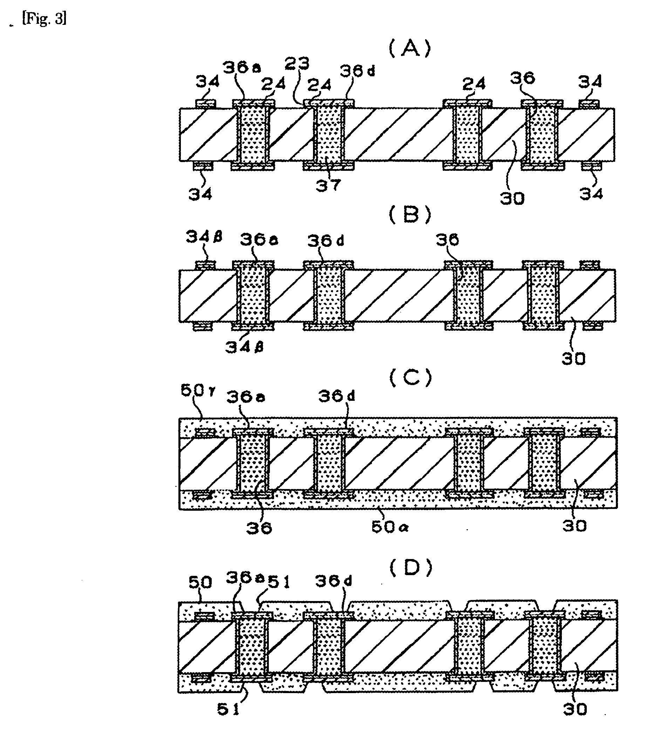

(7) The plated films 23 and 24 and copper foil 32 were removed with etching solution (main ingredient: cupric chloride) from the sections where no etching resist 25 was formed. Then, the etching resist 25 was removed with 5% KOH to form independent conductor circuits 34 and cover plated layers 36a and 36d covering the filler 37 (see Fig. 3 (A)).

(8) On the surfaces of the conductor circuit 34 and the cover plated layers 36a and 36d that covered the filler 37 was formed a coarse layer (textured layer) 348 of 2.5µm in thickness made of an Cu-Ni-P alloy. On the surface of the coarse layer 348 was formed a Sn layer of 0.3µm in thickness (see Fig. 3 (B); the Sn layer is not shown in the drawing).

(9) The interlayer resin insulation layer 50 was formed by the following method: a resin film for the interlayer resin insulation layer (made by Ajinomoto Co., Inc.; brand name, ABF-45SH) 50, which was slightly larger than the substrate, was placed on both surfaces of the substrate; it was preliminarily attached to the substrate under the conditions of 0.45 MPa (pressure), 80°C (temperature), and 10 seconds (pressure bond time) and then sheared; and it was completely attached by using a vacuum laminator (Fig. 3 (C)) in the following manner: the resin film for the interlayer resin insulation layer was completely attached to the substrate under the conditions of 67 Pa (degree of vacuum), 0.47 MPa (pressure), 85°C (temperature), and 60 seconds (pressure bond time), followed by thermosetting for 40 minutes at 170°C.

(10) The opening 51 was formed for a via hole on the interlayer resin insulation layer 2 using CO₂ gas laser (wavelength: 10.4µm) under the conditions of 4.0mm (beam radius), a top hat mode, 3∼30 µsec (pulse width), 1.0 ∼ 5.0mm (radius of the open hole of a mask), and 1∼3 shots (Fig. 3 (D)). The abovementioned laser conditions were adjusted in such a way that the bottom radius of a via hole on the cover plated layers 36a and 36d became 22.5µm. Also, the position of the via hole was adjusted by reading an alignment mark used for laser machining and processing it following the alignment standard or after proper correction. In the first embodiment, the outer circumference of the bottom of the via hole contacted a circle having a radius ((R) + (r)/3) from the center of gravity of the throughhole, and the bottom of the via hole stayed inside the circle.

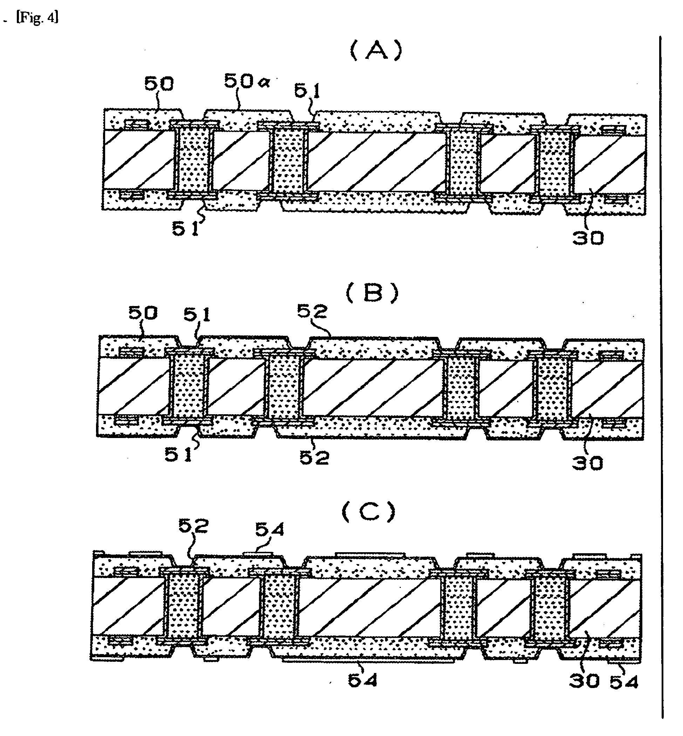

(11) The substrate in which the opening 51 for the via hole had been formed was immersed in a solution containing 60 g/L of permanganic acid for ten minutes at 80°C to remove particles that had remained on the surface of the interlayer resin insulation layer 2. As a result, a coarse surface 50 was formed on the surface of the interlayer resin insulation layer 50 including the inner wall of the opening 51 for the via hole (Fig. 4 (A)).

(12) The above-treated substrate was immersed in a neutralizing solution (made by Shipley Company L.L.C.) and then washed with water.

Furthermore, the nucleus of a catalyst was attached to the surface of the interlayer resin insulation layer and the inner wall of the opening for the via hole by applying a palladium catalyst to the surface of the substrate that had been made coarse on its surface (depth of the coarseness: 3µm). In other words, the substrate was immersed in a catalyst solution containing palladium chloride (PbC₁₂) and stannous chloride (SnC₁₂) in order to deposit metal palladium, thereby providing the catalyst.

(13) The substrate provided with the catalyst was immersed in an electroless copper plating solution (Thrucup PEA) manufactured by Uemura & Co. Ltd. to form an electroless copper plating film of 0.3 - 3.0µm in thickness on the entire coarse surface. Thus, the electroless copper plating film 52 was formed on the surface of the interlayer resin insulation layer 50 of the substrate including the inner wall of the opening 51 for the via hole (Fig. 4(B)).

### [Electroless plating conditions]

At 34°C (liquid temperature) for 45 minutes.

(14) A commercially available photosensitive dry film was attached on the substrate on which the electroless copper plating film had been formed, and a mask was mounted. Then, it was exposed to light (110 mJ/cm²) and developed with 0.8% sodium carbonate aqueous solution to form a plating resist 54 of 25µm in thickness (Fig. 4 (C)).

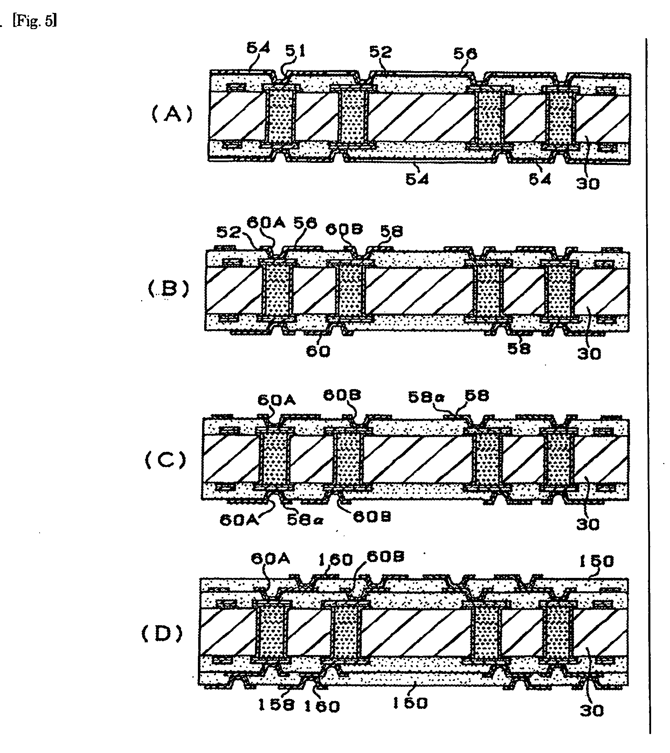

(15) The substrate was washed with water at 50°C to remove grease. Subsequently, it was washed with water at 25°C, followed by sulfuric acid. Then, electrolytic plating was carried out under the conditions as shown below so as to form an electrolytic copper plating film 56 of 15µm in thickness on the section where the plating resist 54 had not been formed (Fig. 5 (A)).

### [Electrolytic plating solution]

| | |
|---|---|
| Sulfuric acid | 2.24 mol/L |
| Copper sulfate | 0.26 mol/L |
| Additive (made by Atotec Japan; brand name, Caparasid GL) | 19.5 mL/L |

### [Electrolytic plating conditions]

| | |
|---|---|
| Current density | 1 A/dm² |
| Time | 70 minutes |
| Temperature | 22±2°C |

(16) After removing the plating resist 54 with 5% KOH, the electroless plating film under the plating resist was removed by an etching process with a mixture of sulfuric acid and hydrogen peroxide to form independent conductor circuit 58 and via holes 60A and 60B (Fig. 5 (B)).

(17) By using the same process as in the above (4), the coarse surface 58 was formed on the surfaces of the conductor circuit 58 and via holes 60A and 60B. The conductor circuit 58 on the lower layer was 15µm in thickness (Fig 5 (C)). However, the conductor circuit on the lower layer may be 5 - 25µm in thickness.

(18) By repeating the above processes (9) - (17), an interlayer insulation layer 150, that is, the upper layer that has conductor circuits 158 and via holes 160 was formed. Thus, a multi-layer wiring board was made (Fig 5(D)). The bottom radius of the via hole 160 was adjusted to 25µm.

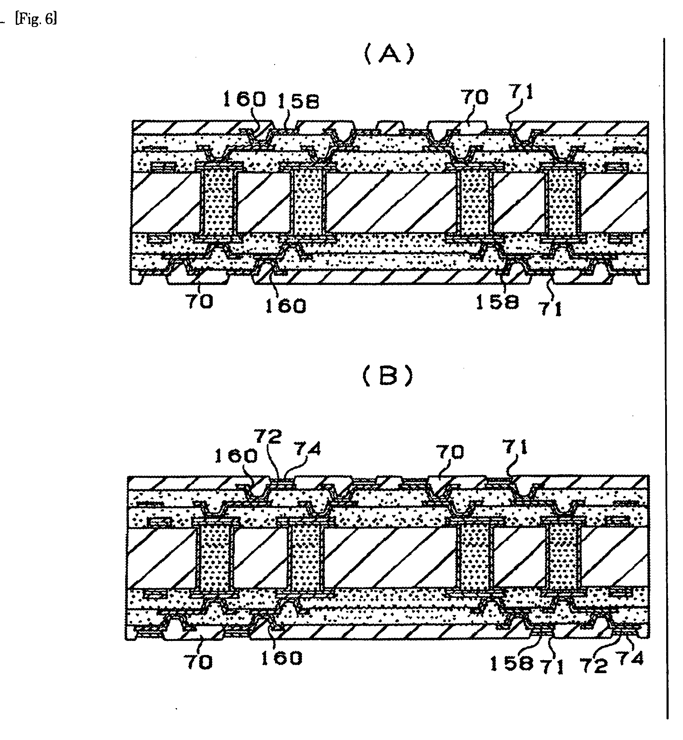

(19) A commercially available solder resist composition 70 was applied in the thickness of 20µm both surfaces of the multi-layer wiring board and dried for 20 minutes at 70°C followed by 30 minutes at 70°C. After tightly attaching to the solder resist layer 70 a photo mask of 5mm in thickness on which a pattern of the opening section of the solder resist was drawn, it was exposed to ultraviolet rays (1000 mJ/cm²) and then developed with DMTG solution to form the opening 71 of 200µm in diameter (Fig. 6 (A)).

Then, the solder resist layer was solidified by heat processes at 80°C for one hour, at 100°C for one hour, at 120°C for one hour, and at 150°C for three hours to form solder resist pattern layers of 15 ∼ 25µm in thickness that had opening sections.

(20) The substrate on which the solder resist layer 70 had been formed was immersed in an electroless nickel plating solution (pH: 4.5) containing nickel chloride (2.3 x 10⁻¹ mol/L), sodium hypophosphite (2.8 x 10 ⁻¹ mol/L), and sodium citrate (1.6 x 10 ⁻¹ mol/L to form a nickel plated layer 72 (5µm in thickness) in the opening 71. Subsequently, the substrate was immersed in an electroless gold plating solution containing gold potassium cyanide (7.6 x 10⁻³ mol/L), ammonium chloride (1.9 x 10 ⁻¹mol/L), sodium citrate (1.2 x 10 ⁻¹ mol/L, and sodium hypophosphite (1.7 x 10 ⁻¹ mol/L) for 7.5 minutes at 80°C to form a gold plated layer 74 of 0.03µm in thickness on the nickel plated layer 72 (Fig. 6 (B)). Besides nickel and gold, a single layer of Sn or precious metal (gold, silver, palladium, platinum, etc.) may be formed.

(21) The opening 71 of the solder resist layer 70 was printed with solder paste containing Sn-Pb on the surface of the substrate for mounting an IC chip. After that, the opening of the solder resist layer on the other surface was printed with solder paste containing Sn-Sb. Then, solder bumps (solder bodies) were formed by reflow soldering at 200°C to make a multi-layer printed wiring board having solder bumps 78U and 78D (Fig. 7).

An IC chip 90 was mounted through the solder bumps 78U. Then, the wiring board was mounted on the daughterboard 94 through the solder bumps 78D (Fig. 8).

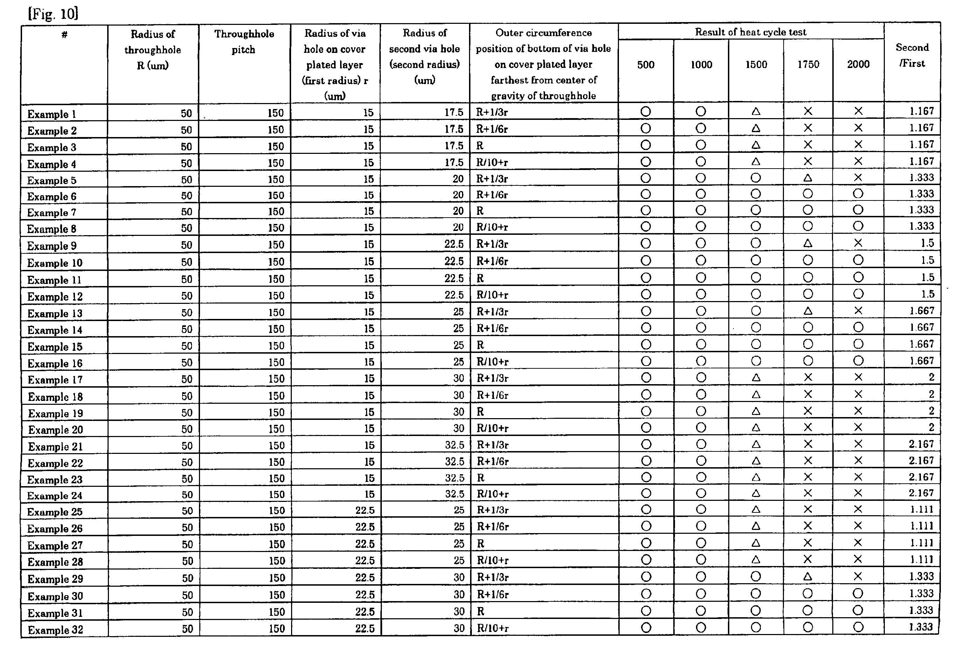

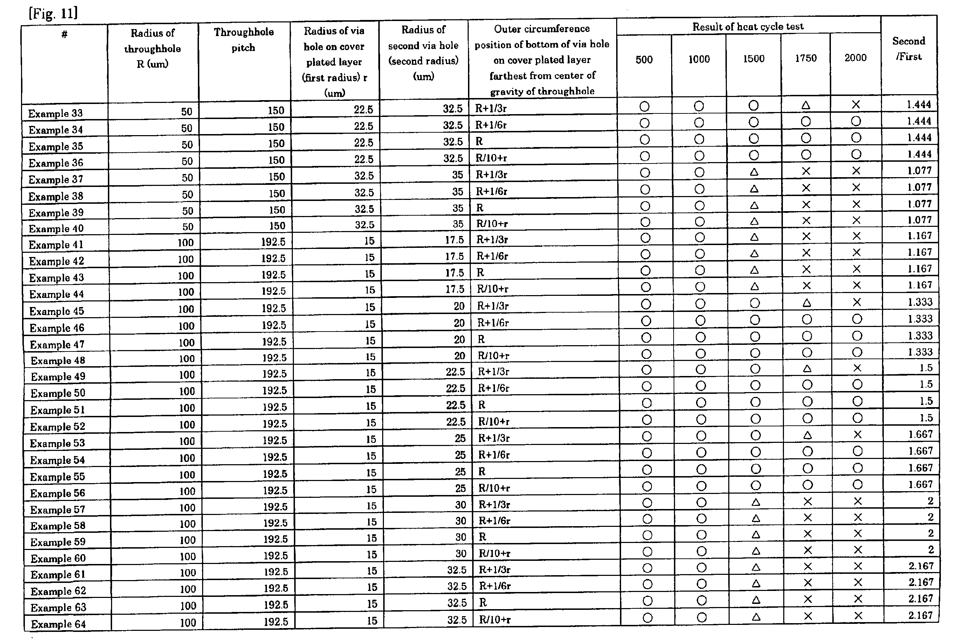

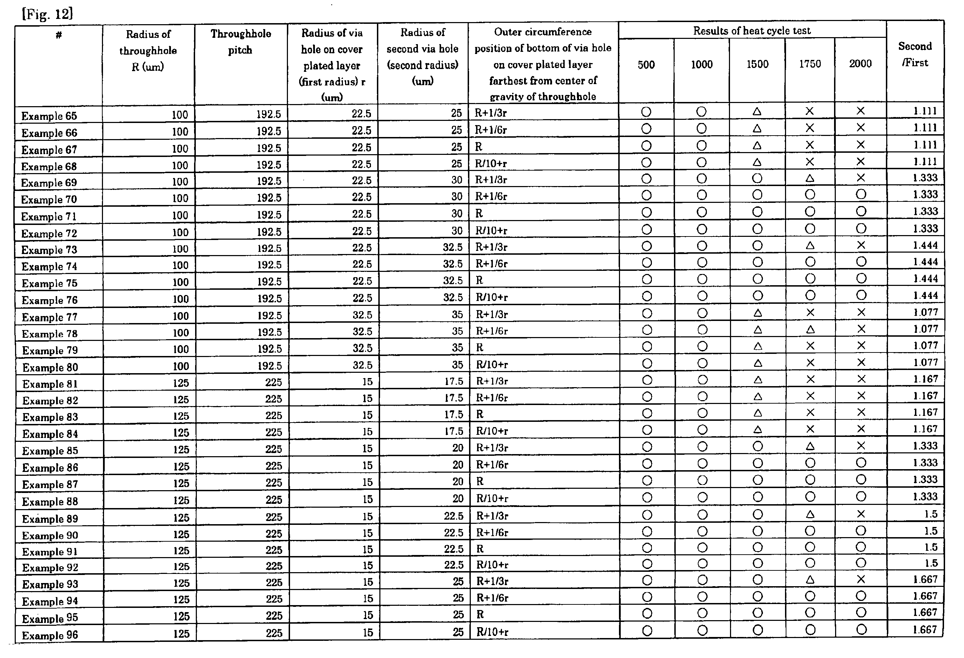

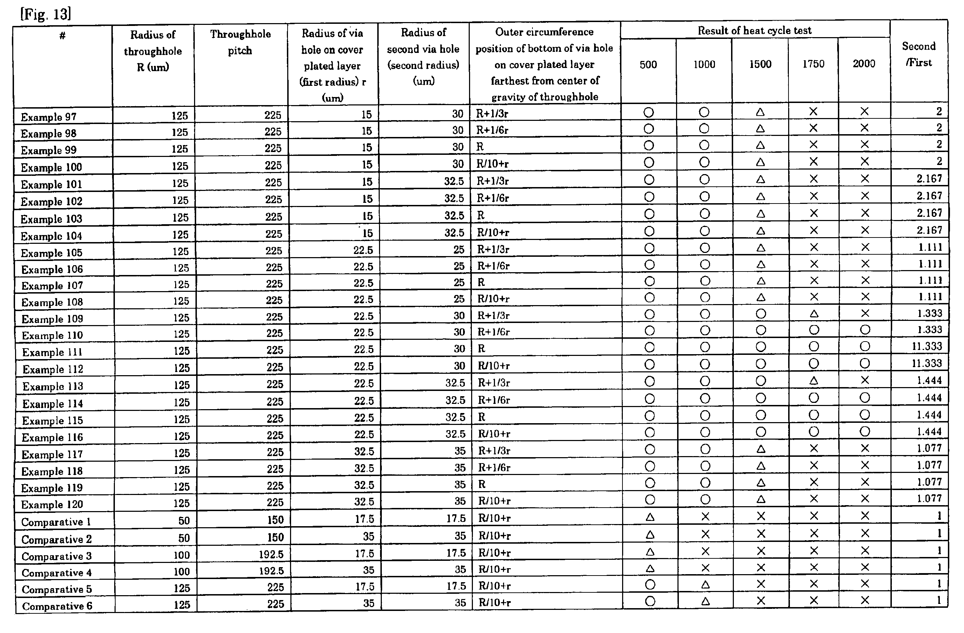

Various examples are given below to demonstrate the effect of the multi-layer printed wiring board 10 according to the first embodiment. First, the following is discussed: the relationship between the rate of change in electric resistance after repeated heating and cooling and various factors including the bottom radius of a via hole on the cover-like conductor layer, the position of the bottom of a via hole on the cover-like conductor layer, the bottom radius of a second via hole, the radius of a throughhole, and a pitch of a throughhole. Multi-layer printed wiring boards of Examples 1 - 120 and Comparative Examples 1∼6 (Fig. 10∼ Fig. 13) were made based on the abovementioned first embodiment. Specifically, the radius of the opening 16 was varied in Fig. 1 (B) by changing the radius of a drill used for drilling. The pitch was varied by inputting data on drilling position into the drill. The bottom radii of a via hole on the cover-like conductor layer and a second via hole were altered by adjusting laser conditions as shown in the process (10). The position of the bottom of a via hole on the cover-like conductor layer was decided by setting an amount of correction to an alignment mark position for a laser processing machine as shown in the process (10). An IC chip was then mounted on each multi-layer printed wiring board of various examples and comparative examples. After that, sealing resin was filled in between the IC chip and the multi-layer printed wiring board to make a substrate mounted with an IC chip. The electric resistance of an IC-mediated specific circuit (electric resistance between a pair of electrodes that was electrically connected to the IC chip and exposed on the surface of the IC-mounted substrate opposite to the surface where the IC chip was mounted) was measured and set as an initial value. Then, a heat cycle test was conducted on those IC-mounted substrates for 2000 cycles (one cycle: - 55 degrees for 5 minutes and 125 degrees for 5 minutes). The electric resistance was measured at the 500th, 1000th, 1500th, 1750th, and 2000th cycle of the heat cycle test to find the rate of change relative to the initial value (100 x (measured value - initial value) / initial value (%)). Fig. 10 - Fig. 13 show the results. In the drawings, the rate of change of electric resistance was shown as follows: "good" (O) if the rate of change was ±5% or less; "normal" (Δ) if it was ±5 ∼ 10%; and "poor" (×) if it exceeded ±10. The target specification was such that the rate of change was ±10% or less (i.e., "good" or "normal" in assessment) at the 1000th cycle. "Acceptable" ones were ± 10% or less.

In Examples 1∼ 120, the bottom of a via hole formed on the cover like conductor layer was placed inside a circle having a radius ((R) + (r)/3) from the center of gravity of a throughhole, and the bottom radius of the via hole on the cover-like conductor layer (hereinafter "the first radius") was made smaller than the bottom radius of a via hole (a second via hole) formed on the second interlayer resin insulation layer (hereinafter "the second radius"). Those examples met at least the target specification and were acceptable even at the 1500th cycle ((R) is the radius of a throughhole; (r) is the bottom radius of a via hole on the cover-like conductor layer). On the other hand, in Comparative Examples 1∼6, the bottom of a via hole formed on the cover-like conductor layer was also placed inside a circle having a radius ((R) + (r)/3) from the center of gravity of a throughhole, but the bottom radius of the via hole on the cover like conductor layer was equal to the second radius. They were "normal" or "poor" at the cycle of the target specification, and all of them were "poor" at the 1500th cycle. In Comparative Examples 1∼6, the bonding between the cover-like conductor layer and a via hole on the cover-like conductor layer became strong with respect to stress because the first radius and the second radius were equal. This is because the stress between the cover-like conductor layer and a via hole on the cover-like conductor layer was small. As a result, it became difficult for a via hole on the cover-like conductor layer and insulation layers around it to deform so as to reduce the stress. Therefore, it is speculated that the stress during heating and cooling cycles was concentrated on the bottom of a second via hole and the conductor layer (land) 58 on the lower layer, which weakened the bonding between the bottom of the second via hole and the land and resulted in a rise of connection resistance.

The comparison between Comparative Examples 1- 4 and Comparative Examples 5 and 6 shows that the target specification was satisfied when the radius of a throughhole and its pitch were low in density even if the first radius was equal to the second radius. However, the results were poor at the 1000th cycle if the first radius and the second radius were equal, and the radius of a throughhole was 100µm or less and its pitch was 385µm or less. It is speculated that this was because the latter had stronger stress. One speculated reason is that deformation of the multi-layer printed wiring board was bigger in Comparative Examples 5 and 6 because a throughhole conductor (copper: 16 ppm) that had a thermal expansion coefficient different from that of the insulative substrate 30 (thermal expansion coefficient: 50 - 60 ppm) was furnished on the insulative substrate in high density. Therefore, it is more significant to apply the present invention to multi-layer printed wiring boards whose throughhole is 100µm or less in radius and pitch is 385µm or less.

As a result of the 1500th and 1750th cycles of Examples 1∼120, it was found that the radius of a second via hole with respect to the radius of a first via hole was preferably 1.3 ∼ 1.7. It is speculated that this was because the bonding power / stress became substantially equal in this range because of the difference of stress between both sections, even if the bonding force (adhesive force per unit area x bonding area) between the cover-like conductor layer and the bottom of a via hole on the cover-like conductor layer was weaker than the bonding force between a second via hole and the conductor layer (land) 58 on the lower layer. (If there is any difference between them, stress is concentrated on the weak side, resulting in problems including detachment.)

Furthermore, from the results of the 1750th and 2000th cycles, it was found that the bottom of a via hole on the cover-like conductor layer is preferably positioned inside ((R) + (r)/6). As the bottom of a via hole on the cover-like conductor layer has more portions outside of ((R) + (r)/6) and inside of ((R) + (r)/3), more portions are positioned above the insulative substrate. It is therefore considered that deformation occurs under the influence of physical properties (Young's modulus, Poisson ratio, thermal expansion coefficient, and the like) of both of the throughhole and insulative substrate and complicated behavior results, which leads to the transmission of more stress to a second via hole.

### Brief Explanation of the Drawings

[Fig. 1] A process drawing showing the production method of the multi-layer printed wiring board according to the first embodiment of the present invention.
[Fig. 2] A process drawing showing the production method of the multi-layer printed wiring board according to the first embodiment.
[Fig. 3] A process drawing showing the production method of the multi-layer printed wiring board according to the first embodiment.
[Fig. 4] A process drawing showing the production method of the multi-layer printed wiring board according to the first embodiment.
[Fig. 5] A process drawing showing the production method of the multi-layer printed wiring board according to the first embodiment.
[Fig. 6] A process drawing showing the production method of the multi-layer printed wiring board according to the first embodiment.
[Fig. 7] A sectional view of the multi-layer printed wiring board according to the first embodiment.
[Fig. 8] A sectional view showing an IC chip mounted the multi-layer printed wiring board according to the first embodiment.
[Fig. 9] A plan view showing the cover plated layers of throughholes.
[Fig. 10] A table showing the assessment results of examples.
[Fig. 11] A table showing the assessment results of examples.
[Fig. 12] A table showing the assessment results of examples.
[Fig. 13] A table showing the assessment results of examples and comparative examples.

### Explanation of Reference Numerals

30. Substrate
34. Conductor circuit
36. Throughhole
36a. Cover plated layer (throughhole land)
36b. Sidewall conductor layer
36d. Cover plated layer (throughhole land)
40. Resin filled layer
50.interlayer resin insulation layer
58. Conductor circuit
60A, 60B. Via hole
70. Solder resist layer
71. Opening
78U, 78D. Solder bump
160. Via hole

## Claims

1. A multi-layer printed wiring board, wherein a first interlayer resin insulation layer, a first via hole having bottom radius r comprised of an electroless plating film and an electrolytic plating film, and a conductor circuit are laminated on a core substrate having a throughhole having radius R, and wherein a second interlayer resin insulation layer, a second via hole comprised of an electroless plating film and an electrolytic plating film, and a conductor circuit are laminated on the first interlayer resin insulation layer,
**characterized in that**
a cover-like conductor layer is formed at an end of the throughhole so as to close the throughhole, that the bottom of the first via hole is placed within a region of a radius D = (R + r/3) from the center of gravity of the throughhole, and that the radius of the bottom of the first via hole formed on the cover-like conductor layer is smaller than the radius of the bottom of the second via hole.

2. A multilayer printed wiring board according to claim 1, wherein the first via hole placed on the cover-like conductor layer of which a part of the bottom is outside of the region of the throughhole and all parts of the bottom are placed within the region of the radius D = (R + r/3) from the center of gravity of the throughhole.

3. A multi-layer printed wiring board according to claim 1, wherein the cover-like conductor layer protrudes only in a direction that the first via hole is mounted relative to an opening of the throughhole.

## Patentansprüche

1. Eine mehrschichtige gedruckte Leiterplatte, wobei eine erste Zwischenschicht-Harz-Isolationsschicht, ein erstes Kontaktloch mit einem Bodenradius r, das einen stromlosen Beschichtungsfilm und einen elektrolytischen Beschichtungsfilm umfasst, und ein Leiterkreis auf ein Kernsubstrat laminiert sind, das ein Durchgangsloch mit einem Radius R hat, und wobei eine zweite Zwischenschicht-Harz-Isolationsschicht, ein zweites Kontaktloch, das einen stromlosen Beschichtungsfilm und einen elektrolytischen Beschichtungsfilm umfasst, und ein Leiterkreis auf die erste Zwischenschicht-Harz-Isolationsschicht laminiert sind; **dadurch gekennzeichnet, dass**
eine abdeckungsartige Leiterschicht derart an einem Ende des Durchgangslochs ausgebildet ist, dass das Durchgangsloch verschlossen wird, dass der Boden des ersten Kontaktlochs innerhalb eines Bereichs mit einem Radius D=(R + r/3) vom Schwerpunkt des Durchgangslochs platziert wird, und dass der Radius des Bodens des ersten Kontaktlochs, ausgebildet auf der abdeckungsartigen Leiterschicht, kleiner als der Radius des Bodens des zweiten Kontaktlochs ist.

2. Eine mehrschichtige gedruckte Leiterplatte nach Anspruch 1, wobei das erste Kontaktloch, das auf der abdeckungsartigen Leiterschicht platziert ist, von dem sich ein Teil außerhalb des Bereichs des Durchgangslochs befindet, und alle Teile des Bodens innerhalb des Bereichs mit dem Radius D=(R + r/3) vom Schwerpunkt des Durchgangslochs platziert sind.

3. Eine mehrschichtige gedruckte Leiterplatte nach Anspruch 1, wobei die abdeckungsartige Leiterschicht nur in die Richtung hervortritt, in der das erste Kontaktloch angebracht ist relativ zu einer Öffnung des Durchgangslochs.

## Revendications

1. Carte de câblage imprimée à plusieurs couches, dans laquelle une première couche d'isolation intercouche de résine, un premier trou d'interconnexion présentant un rayon de fond r composé d'un film de placage sans courant et d'un film de placage électrolytique, et un circuit conducteur sont stratifiés sur un substrat formant coeur possédant un trou traversant présentant un rayon R, et dans laquelle une seconde couche d'isolation intercouche de résine, un second trou d'interconnexion composé d'un film de placage sans courant et d'un film de placage électrolytique, et un circuit conducteur sont stratifiés sur la première couche d'isolation intercouche de résine,
**caractérisée en ce qu'**une couche conductrice semblable à un couvercle est formée au niveau d'une extrémité du trou traversant de façon à fermer le trou traversant, **en ce que** le fond du premier trou d'interconnexion est placé à l'intérieur d'une région d'un rayon D = (R + r/3) à partir du centre de gravité du trou traversant, et **en ce que** le rayon du fond du premier trou d'interconnexion formé sur la couche conductrice semblable à un couvercle est plus petit que le rayon du fond du second trou d'interconnexion.

2. Carte de câblage imprimée à plusieurs couches selon la revendication 1, dans laquelle le premier trou d'interconnexion, placé sur la couche conductrice semblable à un couvercle dont une partie du fond est à l'extérieur de la région du trou traversant, et toutes les parties du fond sont placées à l'intérieur de la région du rayon D = (R + r/3) à partir du centre de gravité du trou traversant.

3. Carte de câblage imprimée à plusieurs couches selon la revendication 1, dans laquelle la couche conductrice semblable à un couvercle dépasse seulement dans un sens en ce que le premier trou d'interconnexion est monté par rapport à une ouverture du trou traversant.
